# EUROPEAN PATENT APPLICATION

(11) **EP 2 600 384 A2**
(43) Date of publication of application: **05.06.2013**
(21) Application number: 12193238.8
(22) Date of filing: 19.11.2012
(51) Int. Cl.: H01J 37/32

(54) **A device for applying electromagnetic microwave radiation in a plasma inside a hollow glass substrate tube, and method for manufacturing an optical preform.**

(30) Priority: 01.12.2011 NL 2007917
(71) Applicant: Draka Comteq B.V., 1083 HJ Amsterdam (NL)
(72) Inventor: MIilicevic, Igor, 5707 PW HELMOND (NL); Van Stralen, Mattheus Jacobus Nicolaas, 5036 ST TILBURG (NL); Hartsuiker, Johannes Antoon, 5624 KL EINDHOVEN (NL)
(74) Representative: Algemeen Octrooi- en Merkenbureau

(57) **Abstract**

The present invention relates to a device for applying, in use, electromagnetic microwave radiation in a plasma inside a hollow glass substrate tube, which device comprises an annular space enclosed by a metal wall and further comprising an input port and an applicator slit, which is an output port acting as a radial waveguide, wherein, at said input port, a first end of an elongated microwave guide is attached, said microwave guide being in communication with microwave generating means via a second end of said microwave guide.

## Description

A device for applying electromagnetic microwave radiation in a plasma inside a hollow glass substrate tube, and method for manufacturing an optical preform

The present invention relates to a device for applying, in use, electromagnetic microwave radiation in a plasma inside a hollow glass substrate tube, which device comprises an annular space enclosed by a metal wall and further comprising an input port and an applicator slit, which is an output port acting as a radial waveguide, wherein, at said input port, a first end of an elongated microwave guide is attached, said microwave guide being in communication with microwave generating means via a second end of said microwave guide.

The present invention further relates to a method for manufacturing an optical fibre preform by means of such a device, and an optical fibre obtained from such an optical fibre preform.

The device mentioned here is know from US Patent No. 7,650,853 in the name of the present inventors. US Patent No. 7,650,853 relates to the provision of a microwave applicator by means of which a stable plasma having favourable geometric properties can be generated and maintained, which microwave radiation has only one electromagnetic field distribution at least in one direction perpendicularly to the propagation direction.

From European Patent 1 1867 610 in the name of the present inventors is known an apparatus for carrying out a PCVD deposition process, wherein in a coaxial waveguide an antenna is movable, which antenna bisects a feed waveguide and wherein a guide element is present in the interior of the feed waveguide.

From US patent No. 5,223,308 there is known a deposition apparatus which comprises a microwave generator, in which a rectangular microwave waveguide is used for generating an electromagnetic field of intense microwave energy in a space in which an elongated hollow tube is moved continuously. Such a tube is formed of a synthetic resin, for example a nylon material, wherein a coating of silicon oxide, silicon nitride or silicon oxycarbide is applied by means of the aforesaid apparatus, which tubes are used as pipes for the hydraulic air conditioning system in automobiles in order to thus minimise the loss of liquid coolant, such as freon, into the atmosphere.

US patent application US 2003/0104139 relates to an apparatus for depositing a plasma chemical vapour deposition (PCVD) coating on the interior of a hollow glass tube, wherein an applicator comprising a waveguide and an applicator head is used, which waveguide functions to guide microwaves from a microwave generator to the applicator head. The waveguide has an elongated axis and a rectangular cross-section having a long axis and a short axis and being perpendicular to the elongated axis of the waveguide. A glass tube is positioned within the applicator head, and the applicator head is moved over said hollow glass tube, in which a coating is to be deposited, along the longitudinal axis of the tube.

US patent application US 2003/0115909 relates to an apparatus for depositing one or more glass layers on the interior of a hollow substrate tube, wherein an activator space of a microwave applicator surrounds the hollow substrate tube, with the microwaves generating a plasma in the interior of the hollow substrate tube, causing the glass-forming precursors to deposit SiO₂ onto the interior of the substrate tube.

US2004045508 relates to a plasma-activated CVD system in which a cooler for cooling the annular waveguide is provided, whereby it is intended to protect the annular waveguide from heat and attain a safe and stable supply of the microwave. The cooler is disposed between the annular waveguide and the quartz tube as the reaction chamber, i.e. a cooling pipe for passing therethrough of a refrigerant such as water, oil, or gas is mounted to an inner surface of the inner periphery wall of the annular waveguide, thereby constituting the cooler. The cooling pipe is embedded in the inner periphery wall of the annular waveguide.

US4125389 relates to a method of manufacturing an optical fibre by plasma activated deposition in a tube, and to apparatus for such a method, in which a substrate tube of fused silica is placed through a microwave cavity connected to a high power microwave generator by a waveguide. Gas is fed through the tube and cooling gas is passed along the outside of the tube, in the microwave cavity. As a cooling gas, for example, nitrogen, is passed between the metal cavity and the outside wall of the tube.

US4844007 relates to a device for providing glass layers on the inside of a tube, comprising a gas supply device which is connected to one end of the tube, a furnace for heating the tube, a resonator comprising a resonant cavity for generating a plasma in the tube, and means to move the resonator and the tube relatively with respect to each other, a high-frequency generator which is connected to the resonant cavity and a vacuum pump which is connected to the opposite end of the glass tube. The resonator comprises a cooled body comprising a duct for receiving the tube, of which body at least the duct wall consists of a readily heat-conducting metal and in which the wall of the duct facing the tube is provided with a heat-insulating layer. The cooling capacity of the resonator is reduced by the presence of heat-insulating layer and the resonator is cooled via cooling water ducts.

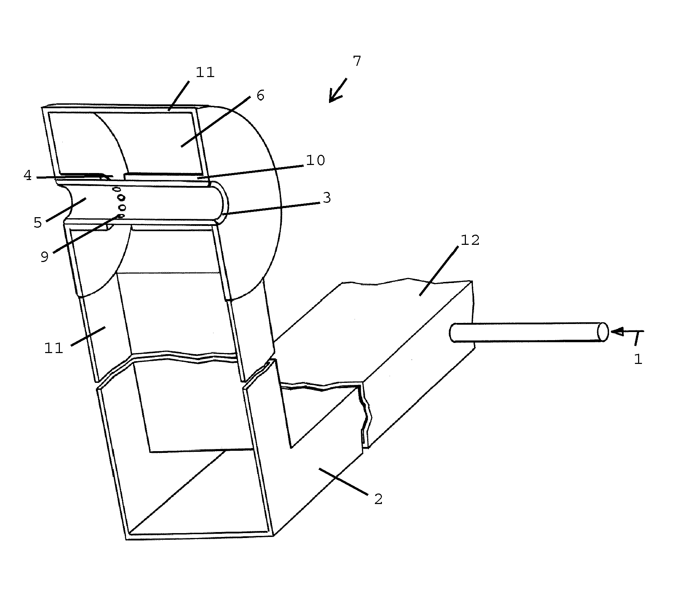

An apparatus for manufacturing optical fibres is known from US patent US 6,849,307 granted to the present inventors, which apparatus may be used within that context for manufacturing a so-called preform, from which an optical fibre can be drawn. According to the method for manufacturing such a preform that is known there from, an elongated vitreous substrate tube (comprised of quartz, for example) is coated on its interior cylindrical surface with layers of doped silica (for example germanium-doped silica). This can be achieved by positioning the substrate tube along the cylindrical axis of a reaction zone and flushing the interior of the tube with a gaseous mixture, for example comprising O₂, SiCl₄ and possible dopants, e.g. GeCl₄. A localized plasma is concurrently generated within a cavity, causing the reaction of Si, O and Ge so as to effect direct deposition of Ge-doped SiO₂ on the interior surface of the substrate tube. Since such deposition only occurs in the vicinity of the localized plasma, the reaction zone must be swept along the cylindrical axis of the tube in order to uniformly coat its whole length. When coating is complete, the tube is thermally collapsed into a massive solid rod having thus a Ge-doped silica core portion and a surrounding undoped silica cladding portion. If an extremity of the rod is heated so that it becomes molten, a thin glass fibre can be drawn from the rod and wound on a reel; said fibre then has a core and cladding portion corresponding to those of the rod. Because the Ge-doped core has a higher refractive index than the undoped cladding, the fibre can function as a waveguide for optical signals, for example for use in propagating optical telecommunication signals. It should be noted that the gaseous mixture flushed through the hollow glass substrate tube may also contain other components; the addition of dopants, e.g. C₂F₆, for example, causes a reduction in the refractive index of the doped silica. It should also be noted that the solid preform may be placed in a so-called jacket tube (comprised of undoped silica, for example) prior to the drawing procedure, so as to increase the quantity of undoped silica relative to doped silica in the final fibre. Another possibility of applying an extra amount of silica is the so-called overcladding by means of a plasma process or outside vapour deposition (OVD) process.

The use of such an optical fibre for telecommunication purposes requires that the optical fibre is substantially free from defects (for example discrepancies in the percentage of dopants, undesirable cross-sectional ellipticity and the like), because, when considered over a large length of the optical fibre, such defects may cause a significant attenuation of the signal being transported. It is important, therefore, to realise a very uniform and reproducible PCVD process, because the quality of the deposited PCVD layers will eventually determine the quality of the optical fibres; thus it is important that the plasma generated in the resonant cavity be rotationally symmetrical (around the cylindrical axis of the cavity). On the other hand, the costs of the production process will be affected advantageously if the preform can be given a larger diameter, because larger fibre lengths can then be obtained from a single preform. Increasing the diameter of the resonant cavity enabling the use of substrate tubes having increased diameters will lead to a plasma having a deteriorated rotational symmetry, and such can only be generated by using a much higher microwave power.

In the aforesaid PCVD apparatus, energy from a device capable of generating microwaves, for example a microwave oven, must be transferred to the annular resonant cavity so as to form a plasma zone in the interior of the substrate tube. This means that the microwaves are supplied to the feed waveguide and can subsequently reach the annular resonant cavity via a waveguide.

The present inventors have found that using so called high doped hollow substrate tubes may cause problems during the inside deposition process of the plasma type. Problems that may occur are related to a melting of the substrate tube, or a partly premature collapse of the substrate tube during the inside deposition phase. These problems will require an early termination of the deposition process. And these problems are highly undesirable form the viewpoint of process stability, but also safety. An option to eliminate these problems is the application of a lower furnace temperature. However, the present inventors found that lowering the furnace temperature may lead to the deposition of lower quality glass layers.

Thus it is an aspect of the present invention to develop a device for carrying out a plasma chemical vapour deposition (PCVD) process, which apparatus enables employing high doped substrate tubes for attaining high deposition rates.

Another aspect of the present invention is to develop a device for carrying out a plasma chemical vapour deposition (PCVD) process in which the deposition of high quality glass layers is guaranteed.

Yet another aspect of the present invention is to provide a device for carrying out a plasma chemical vapour deposition (PCVD) process in which high furnace temperatures are applied during the inside deposition of glass layers in the interior of a hollow substrate tube.

According to the present invention, the device for carrying out a plasma chemical vapour deposition (PCVD) process as mentioned in the introduction is **characterised in that** the device comprises means for cooling at a position near the applicator slit.

When such a special construction of the device is used, i.e. the provision of means for cooling at a position near the applicator slit, an excessive heating of the substrate tube is highly prevented. This construction allows for the use of high doped substrate tubes in a plasma chemical vapour deposition (PCVD) process. The present inventors thus found that when the outside temperature of the hollow substrate tube inside the resonator is kept below its melting point, the substrate tube will remain in the original state, i.e. no sagging or melting will occur. The present inventors are of the opinion that the substrate tube is mostly been heated due to the dissipation of the plasma energy on the inside of the substrate tube.

In a special embodiment said means for cooling comprises means for directing a flow of cooling gas through the interior of said elongated microwave guide. The elongated microwave guide can thus be used for transporting cooling gas in a very efficient way. And this transport of cooling gas will lower the outside temperature of the substrate tube significantly, especially at the location where the heating of the substrate tube in that region is the most significant, especially during the inside deposition process. An example of a cooling gas is compressed air.

In an embodiment of the present invention the annular space is substantially symmetrically about an axis, i.e. the longitudinal axis of the hollow substrate tube when inserted in the present device. Such a symmetrical construction is preferred from a view point of stable microwaves inside the substrate tube.

According to another embodiment of the present device a hollow quartz glass liner tube is located against an inner cylindrical wall of said device, and inside an area enclosed by said annular space, said hollow quartz glass liner tube being provided with one or more openings. The provision of such a liner tube prevents the unwanted adhesion of small fragments coming from the furnace wall and the resonator itself. During the deposition process the hollow substrate tube is located in the area enclosed by said annular space and surrounded by the liner tube. The provision of openings in the hollow quartz glass liner tube enables the flow of cooling gas in the direction of the outside of the substrate tube.

For symmetrical and efficient cooling purposes it is preferred to position the openings for flowing cooling gas around the circumference of the liner tube.

In another embodiment of the present device the liner tube is positioned such that the openings are positioned in the applicator slit for passing cooling gas from the interior of the elongated microwave guide through the applicator slit.

The means for directing a flow of cooling gas preferably comprises a mass flow controller for controlling the flow of cooling gas directed to the interior of said elongated microwave guide.

In an embodiment of the present invention the microwave guide is of rectangular cross-section. According to another embodiment the microwave guide is of circular cross-section.

The present invention further relates to a method for manufacturing an optical fibre preform by means of a plasma chemical vapour deposition process, which method comprises the steps of:
carrying out a plasma chemical vapour deposition process for depositing one or more doped or undoped layers of silica on the interior surface of an elongated glass substrate tube,
subjecting the substrate tube to a thermal contraction treatment so as to form a solid preform, wherein the deposition takes place in the present device. More in detail, a hollow substrate tube is placed inside an area enclosed by an annular space, wherein the substrate tube and the annular space are substantially coaxial, and wherein the annular space is moved reciprocating along the length of the substrate tube so as to effect the deposition of one ore more doped or undoped layers of silica on the interior of the substrate tube, wherein during said deposition a cooling gas is supplied to the interior of the annular space.

In a special embodiment of the present method, the cooling gas is supplied through the interior of the elongated microwave guide.

The cooling gas is selected from the group of air, oxygen, nitrogen and carbon dioxide, and combinations thereof, preferably supplied as a gas having an over pressure of at least 0.1 bar.

The flow of cooling gas supplied to the interior is such that the temperature prevailing at the outside of the glass substrate tube is lower than the melting temperature of the glass substrate tube.

According to an embodiment the temperature prevailing at the outside of the glass substrate tube is the temperature of the glass substrate tube at a position near the applicator slit during said deposition process.

The speed of the resonant cavity during the present deposition process is below 300 mm/min under the conditions of a microwave power in the range of 3 - 10 kW and a flow rate of the cooling gas is preferably in the range of 25-250 slm.

The present invention will now be explained in more detail with reference to a single figure, in which connection it should be noted, however, that the present invention is by no means limited to such a special embodiment.

In the appended sole figure, the apparatus for carrying out a plasma chemical vapour deposition (PCVD) process is schematically indicated at 7. The apparatus 7 comprises a cavity 6, which is substantially annular in shape, having an inner cylindrical wall 10 and an outer cylindrical wall 11. The inner cylindrical wall 10 comprises a slit 4, which extends preferably in a full circle around the cylindrical axis (in a plane perpendicular to the plane of the figure). For the deposition process a hollow quartz glass substrate tube is positioned in an area enclosed by said annular space. Since deposition of glass layers only occurs in the vicinity of the plasma zone, cavity 6 (and thus the plasma zone) must be moved along the cylindrical axis so as to coat the glass substrate tube (not shown) uniformly along the entire length thereof.

An elongated microwave guide 2 is at a first side 11 thereof connected to the device 7 as an input port and at its second side 12 thereof connected to microwave generating means, such as a magnetron or a klystron (not shown) for supplying microwaves to the elongated microwave guide 2, which microwaves subsequently find their way in device 7 and finally generate a plasma zone in the interior of the glass substrate tube (not shown) at a position surrounded by cavity 6. The plasma zone thus formed creates conditions such that the glass-forming precursors being supplied to the interior of the substrate tube will deposit on the inner wall of the substrate tube so as to form one or more glass layers on its interior.

In the annular space 5 of cavity 6 is located a hollow liner tube 3. The outer circumference of liner tube 3 abuts against the inner cylindrical wall 10 of device 7. Liner tube 3 is provided with several openings 9 located around its circumference. A cooling gas is supplied via the elongated microwave guide 2. The flow of cooling gas is controlled through the use of a mass flow controller (not shown). The supply of cooling gas, indicated by arrow 1 and located near the second side 12, takes place preferably through the interior of the elongated wave guide 2 to the outside of the substrate tube positioned in the interior of the annular space of cavity 6. Although the supply of cooling gas is shown in the vicinity of the second side 12 the present invention is not limited to that specific location. In a specific embodiment the position of the supply of cooling gas can for example be chosen at a point close to the first side 11.

During the deposition process the hollow substrate tube is surrounded by the liner tube 3, and the outer circumference of the liner tube 3 abuts against the inner cylindrical wall 10 of device 7. The supply of cooling gas at a position near the applicator slit 4 prevents the premature collapse of the substrate tube during the deposition process. During the inside deposition process the substrate tube is positioned in the annular space, and device 7 is reciprocated over the length of the substrate tube between a reversal point at the gas or inlet side and a reversal point at the pump or outlet side. Glass forming precursors are supplied to the interior of the substrate tube. The microwaves supplied to the cavity 6 will create plasma conditions and glass layers will be deposited on the interior wall of the hollow substrate tube.

After the deposition process the substrate tube will be collapsed in a massive solid form. The thus obtained massive solid form can be provided additionally with one or more glass layers on the outside of the massive solid form. The final preform will be placed in a draw tower and, due to the heating of one of its ends, a glass fibre will be drawn and wound on a reel.

## Claims

1. A device for applying, in use, electromagnetic microwave radiation in a plasma inside a substrate tube, which device comprises an annular space enclosed by metal walls and comprising an input port and an applicator slit, which is an output port acting as a radial waveguide, wherein at the input port a first end of an elongated microwave guide is attached, said microwave guide is in communication with microwave generating means via a second end of said microwave guide, **characterized in that** the device comprises means for cooling at a position near the applicator slit.

2. A device according to claim 1, **characterized in that** said means for cooling comprises means for directing a flow of cooling gas through the interior of said elongated microwave guide.

3. A device according claim 1 or 2, **characterized in that** the annular space is substantially cylindrically symmetric about an axis.

4. A device according to claim 1-3, **characterized in that** the a hollow quartz glass liner tube is located against an inner cylindrical wall of said device, and inside an area enclosed by said annular space, said hollow quartz glass liner tube being provided with one or more openings.

5. A device according to claim 4, **characterized in that** said openings are positioned around the circumference of said liner tube.

6. A device according to claims 4-5, **characterized in that** said liner tube is positioned such that said openings are positioned near the applicator slit for passing cooling gas from the interior of said elongated microwave guide through said applicator slit.

7. A device according to any one or more of the preceding claims, **characterized in that** said means for directing a flow of cooling gas comprises a mass flow controller for controlling the flow of cooling gas directed to the interior of said elongated microwave guide.

8. A device according to any one or more of the preceding claims, **characterized in that** the microwave guide is of rectangular cross-section.

9. A device according to any one or more of the preceding claims 1-7 **characterized in that** the microwave guide is of circular cross-section.

10. An apparatus for depositing, by means of a Plasma Chemical Vapour Deposition process, one or more of glass layers on the inner side of a hollow glass tube disposed of the device according to any one or more of the claims 1- 9.

11. A method for manufacturing an optical preform by means of a Plasma Chemical Vapour Deposition process, which method comprises the following steps: carrying out a Plasma Chemical Vapour Deposition process for depositing one or more doped or undoped layers of silica on the interior surface of an elongated glass substrate tube, subjecting the substrate tube to a thermal contraction treatment so as to form a solid preform, **characterized in that** said plasma chemical vapour deposition process is carried out with a device as defined in any one or more of the claims 1-10, wherein the substrate tube is placed inside an area enclosed by said annular space, wherein said substrate tube and said annular space are substantially coaxial, and wherein the annular space is moved reciprocatingly along the length of the substrate tube so as to effect the deposition of one or more doped or undoped layers of silica on the interior of the substrate tube, wherein during said deposition a cooling gas is supplied to the interior of said annular space.

12. A method according to claim 11, **characterized in that** said cooling gas is supplied through the interior of said elongated microwave guide, in which said cooling gas is preferably a gas selected from the group of air, nitrogen, oxygen and carbon dioxide, and combinations thereof, preferably supplied under an over pressure of at least 0,1 bar.

13. A method according to any one or more of claims 11-12, **characterized in that** the flow of cooling gas supplied to the interior of said cavity is such that the temperature prevailing at the outside of the glass substrate tube is lower than the melting temperature of said glass substrate tube.

14. A method according to claim 13, **characterized in that** the temperature prevailing at the outside of the glass substrate tube is the temperature of the glass substrate tube at a position near the applicator slit during said deposition process.

15. A method according to any one or more of claims 11-14, **characterized in that** the speed of the resonant cavity during said deposition process is below 300 mm/min under the conditions of a microwave power in the range of 3-10 kW and a flow rate of cooling gas in the range of 25-250 slm.
